## Europäisches Patentamt

## European Patent Office

## Office européen des brevets

(19)

(11) Publication number: **0 001 925**
**B1**

(12)  **EUROPEAN PATENT SPECIFICATION**

(45) Date of publication of patent specification: **02.09.81**

(21) Application number: **78300588.7**

(22) Date of filing: **02.11.78**

(51) Int. Cl.³: **H 03 H 7/32, H 04 N 9/00, H 01 P 9/00**

(54) **Dual section distributed parameter delay-line.**

(30) Priority: **04.11.77 US 848541**

(43) Date of publication of application:
**16.05.79 Bulletin 79/10**

(45) Publication of the grant of the European patent:
**02.09.81 Bulletin 81/35**

(84) Designated Contracting States:
**BE CH DE FR GB NL SE**

(56) References cited:
**DE - B - 1 240 599**
**GB - A - 733 763**
**NL - A - 67 09382**
**US - A - 2 703 389**

(73) Proprietor: **SPRAGUE ELECTRIC COMPANY**
**North Adams Massachusetts 01247 (US)**

(72) Inventor: **De Keyser, André**
**Ninovesteenweg 465**
**Ronse (BE)**
Inventor: **Seynaeve, Laurent**
**Sparrentuin 12**
**St. Ellois-Vijve (BE)**

(74) Representative: **Crawford, Andrew Birkby et al,**
**A.A. THORNTON & CO. Northumberland House**
**303-306 High Holborn**
**London WC1V 7LE (GB)**

Courier Press, Leamington Spa, England.

## Dual section distributed parameter delay-line

This invention relates to a dual section distributed parameter delay line. The preferred use of such an electromagnetic delay line is for delaying the luminance signal in a colour television receiver and the invention will therefore be described in relation to such a use although it has many other uses.

In colour television receiver circuitry, the luminance portion of the picture signal must be delayed, typically by a little less than a microsecond, so that it arrives at the picture tube simultaneously with the chrominance signal. A great variety of lumped-parameter and distributed parameter delay lines have been used for this purpose.

In recent years changes and improvements have been made in other portions of TV receivers which generate relatively large magnetic fields within the receiver. For example, switching-mode high voltage power supplies have been introduced to reduce power consumption. The output transformer in such power supplies radiates electromagnetic energy at a fundamental frequency as high as 35 KHz.

Another source of stray magnetic fields within colour TV receivers is the deflection coil. There is a trend toward the use of so-called precision-in-line (P.I.L.) picture tubes which call for toroidal deflection yokes in place of the saddle type yokes used previously. Experience has shown that the toroidal yokes generate stronger stray fields. These signals usually have a fundamental frequency of approximately 15 KHz.

Manufacturers of these modern colour TV receivers have found that the large stray fields induce unwanted noise voltages into the delay-lines previously used. Among other adverse effects on the performance of the receiver, the black level is seriously altered, the relative position of the delay-line within the receiver is critical which complicates initial tune-up and field adjustments, and visible disturbances of the picture occur.

Several manufacturers have begun to use shielded delay-lines. The shield usually consists of two halves of a ferromagnetic material placed around the delay-line, the halves being connected together and to a point at ground potential in the receiver. Besides the additional costs, such shielded delay-lines are substantially larger and heavier than their non-shielded counterparts.

A shielded delay-line is disclosed in German Patent Specification 1,240,599 which discloses a delay-line comprising two or more sections in side-by-side relationship, each comprising a mandrel on which is wound a coil made up of a plurality of partial coils, adjacent partial coils being wound in opposite directions.

It is an object of the present invention to provide a delay line which will mitigate the effects of large stray fields without having to use a shield.

The present invention provides a distributed parameter electromagnetic delay-line comprising essentially identical delay-line sections (10, 20), each of said sections comprising an elongated mandrel (11, 21) with at least portions (12, 22) of the surface thereof being electrically conductive, a continuous wire coil (14, 24) being wound about the mandrel (11, 21) and insulated from said conductive portions, the conductive portions (12, 22) of each delay-line section (11,21) being electrically interconnected with a coil end (14a) of one and a coil end (24a) of the other of said sections (10, 20) being electrically interconnected, and the mandrels (11, 21) positioned side-by-side with their axes (11a, 21a) being mutually parallel, the interconnected coil ends (14a, 24a) being two laterally adjacent ends, the winding directions of the coils being the same with respect to one axial direction whereby said coil (14, 24) has a continuously distributed capacitance to said conductive surface of said mandrel and a uniform unidirectional magnetic field of slowly varying magnitude having flux lines parallel to said mandrel axes will produce no voltage between the free ends of said interconnected coils characterised in that there are only two delay line sections, in that the mandrel (11, 21) of each section (10, 20) is provided with a single coil forming a uniform winding from one end to the other end thereof along said mandrel (11, 21).

Low frequency components of a magnetic field will thus produce essentially no noise voltages at the input or output of a dual section delay-line of this invention. Further a metal shield having a magnetic permeability near unity may be placed about the delay-line to effectively prevent high frequency components of the magnetic field environment from producing noise in the delay-line, and the minimum spacing between such a nonmagnetic shield and the dual sections may be as close to the sections as 0.15 times the diameter of the coils without substantial degradation of the delay-line bandwidth.

The advantages offered by the invention are that it effectively shields the delay-line from stray magnetic fields but its position within the receiver is not critical and the delay-line is smaller and lighter when provided with a high frequency shield than previous delay lines.

In order that the present invention be more clearly understood embodiments thereof will now be described by way of example with reference to the accompanying drawings, in which:—

Figure 1 shows a delay-line having two distributed parameter delay-line sections

positioned side-by-side, with two continuously wound coils having the same clockwise winding directions;

Figure 2 is a schematic diagram of the delay-line of Figure 1 connected to a signal source and to a load;

Figure 3 shows a packaged delay-line with an outer package portion broken away to reveal the two delay-line sections;

Figures 4 and 5 show two cylindrical delay-line mandrels, each having been slit along its length and flattened to show the full pattern of the conductive "ground plane" coating;

Figure 6 shows in side view yet another mandrel of this invention;

Figure 7 shows in right-end view the mandrel of Figure 6;

Figure 8 shows in side view a distributed parameter delay-line section formed on the mandrel of Figures 6 and 7;

Figure 9 shows in side view a delay-line comprising two sections of the type shown in Figure 8;

Figure 10 shows in left-end view the delay-line of Figure 9; and

Figure 11 is a schematic diagram of the delay-line of Figure 9.

An electromagnetic delay-line of this invention for delaying the luminance signal in a colour television receiver has precisely two essentially identical distributed parameter delay-line sections. Each section includes an elongated mandrel of uniform cross section, such as a cylinder. A continuous length of wire is wound about the mandrel of each section and the mandrel of each section has a conductive surface that serves as the ground plane of the section. The uniformly wound coil is insulated from the ground plane, and thus has a continuously distributed capacitance to the ground plane in an axial direction.

The ground planes of the mandrels of the two sections are electrically interconnected, and a coil end of each of the sections are also interconnected and the axes of the two mandrels are either co-axial or mutually parallel. One end of one coil is connected to one end of the other coil, the connected ends and the winding direction of the coils being chosen so that effectively the winding direction of one of the coils is opposite to that of the other in the sense that an observer travelling along the interconnected coils will observe a winding reversal in going from one to the other of the two sections. Thus a uniform unidirectional magnetic field of slowly varying magnitude having flux lines parallel to the mandrel axes will produce no net voltage between the free ends of the interconnected coils. Thus the low frequency components of a magnetic field will produce essentially no noise voltages at the input or output of a dual section delay-line.

Further a metal shield having a magnetic permeability near unity may be placed about the delay-line to effectively prevent high frequency components of the magnetic field environment from producing noise in the delay-line. The minimum spacing between such a nonmagnetic shield and the dual sections may be as close to the sections as 0.15 times the diameter of the coils without substantial degradation of the delay-line bandwidth.

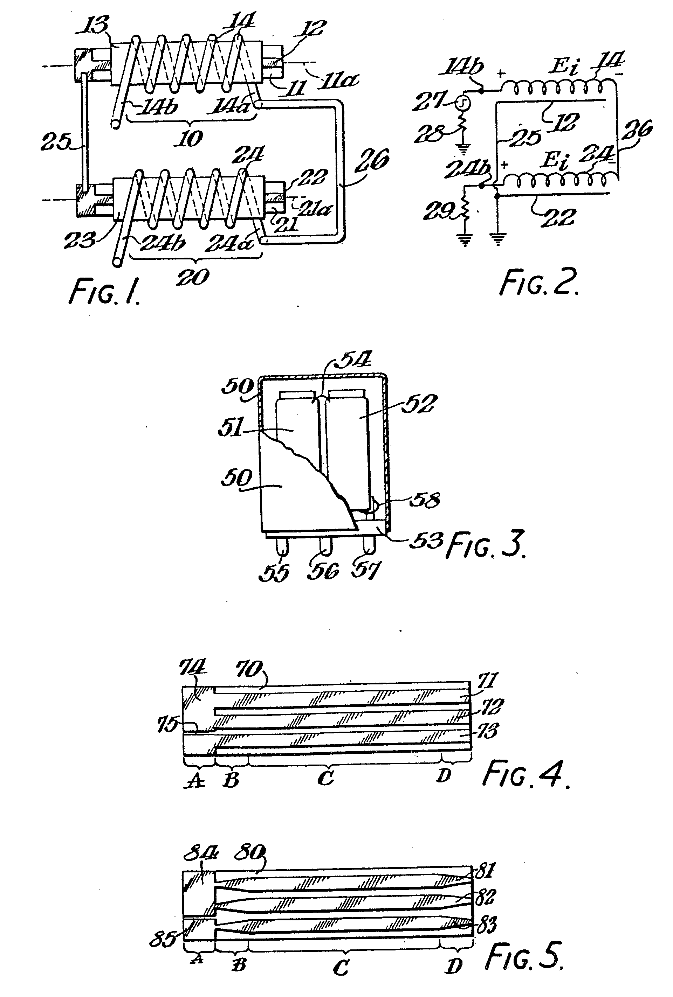

Figure 1 shows a first preferred embodiment of two identical distributed parameter delay-line sections 10 and 20 each having an elongated electrically insulating mandrel 11 and 21 respectively, a conductive coating 12 and 22 respectively on the surface of the mandrel, an electrically insulating film 13 and 23 overlying the respective conductive coating 12, 22, and a continuous wire coil 14 and 24 wound about the mandrel over the insulating film 13, 23.

The conductive coatings 12 and 22 are electrically interconnected by a wire 25 and serve as the "ground plane" of the delay-line. One end 14a of coil 14 is connected by a wire 26 to one end 24a of coil 24 either by a separate wire or by a portion 26 of a continuous length of wire used to form both coils so that the coils form a series circuit. Every turn of the wound coil 14 (or 24) has the same spacing from and the same capacity with respect to the underlying coating 12 (or 22). The mandrels 11 and 21 are preferably circular cylinders but may have other elongated forms with uniform cross sectional areas such as flat plates.

The axis 21a of mandrel 21 is parallel to the axis 11a of mandrel 11. The mandrels are positioned side-by-side, but spaced apart so as to minimize reflections that are generated near the interconnection between the two coils. Typically this requires a coil separation of about one fifth of a coil diameter, depending however upon numerous structural features such as the type, the aspect ratio of the coil, the winding pattern, the pattern of the conductive coating, and the shape and material of the mandrel. Optimum spacing between sections is best determined empirically to achieve proper balance between a small delay-line package with small spacing and a wanted degree of positive mutual inductive coupling which has been found to compensate for an otherwise reduced $L/_c$ ratio of the coil portions near the interconnection therebetween.

In the schematic diagram of Figure 2, the other end 14b of coil 14 is considered to be a free end and is used as the input terminal of the delay-line and the free end 24b of coil 24 is then the output terminal. An ideal voltage source 27 having a series source resistor 28 is shown connected between the input 14b and the ground plane. A load resistor 29 is connected across the output of the delay-line from terminal 24b and the ground plane. These resistors are usually each chosen to have a resistance value equal to the characteristic impedance of the delay-line, so that a signal travelling in either direction along the delay-line will be completely dissipated in one or the other of these resistors and thus will not be reflected back into the delay-line causing distortions in other portions of the signals there. Thus in normal operation a signal produced by voltage source 27 will travel through the delay-line and arrive across the load resistor 29 some fixed time later, namely $T_1 + T_2 = 2T_1$ later, where $T_1$ and $T_2$ are the characteristic delay times of the identical sections 10 and 20, respectively.

Note that relative to one axial direction the winding directions of the two parallel coils 14 and 24 are in the same clockwise direction, but because the coils are parallel to each other with adjacent ends connected together the effect is as if coils were wound in opposite directions. Thus, when a uniform unidirectional magnetic field of varying amplitude is present, a voltage $E_i$ is induced at a given instant of time across coil 10 in the polarity indicated in Figure 2 and the same induced voltage $E_i$ will appear across coil 20 in a polarity that is opposing the voltage induced in the series connected coil 10 and hence no voltage appears across the delay-line.

The above explanation of the magnetic field noise rejection feature of this embodiment must be tempered by the fact that it takes a finite time for a signal induced at any given point within the delay-line to travel to the source or to the load. Thus if the induced voltage has components of frequency ($H_z$) less than about 0.06 times the reciprocal of the delay time (in seconds) of the delay-line, then essentially no induced noise voltage will appear at either the input or the output of the delay-line. Typical delay-times for a colour TV delay-line range between 0.25 to 1 microseconds and such delay-lines made as described above will effectively reject induced noise voltages having components less than 60 KHz.

It was indicated above that a delay-line having a delay time of 1.0 microseconds will effectively suppress low frequency noise of the kind generated in modern T.V. sets having switching type power supplies and P.I.L. (precision-in-line) picture tubes. However, when the noise inducing stray magnetic field has frequency components whose period approaches or is less than the delay time of this dual section delay-line, noise voltages may appear at the input and the output.

This may be understood by considering a stray magnetic field "ramp pulse" that is to say a field whose strength abruptly changes from zero to one, increasing at a constant rate. Such a field pulse will induce a step of voltage in each winding-turn. Each induced step will be delayed a different time before reaching either end of the delay-line. The effect, as seen for example at the output, will be the creation of a noise pulse having a staircase rise and then fall roughly approximating a triangle the base of which is about equal to the total delay time of the delay-line.

In some TV receiver systems the high frequency noise pulses do not have an objectionable effect on the performance; the low frequency magnetic field induced noise being suppressed by a dual section delay-line as described above.

However in receiver systems where the high frequency noise does cause deterioration in system performance, it can be suppressed by providing a simple sheet metal shield about a major portion of the dual section delay-line. Furthermore such a conducting shield may be made of a thin (e.g. 0.15 to 0.5 mm) non-ferrous metal, such as aluminium or copper, which may in practice lie as close as about 0.15 times the outer diameter of the coils without substantial effect on the signal transfer characteristics of the delay-line. The spacing between the shield and the coils of this invention is preferably no greater than about 0.6 times the outer diameter of a coil to provide a small efficient delay-line package. In contrast, prior art ferromagnetic shields must be spaced from the delay-line sections by a distance approximately the same as the coil diameter in order to avoid disadvantageously decreasing the bandwidth of the enclosed delay-line.

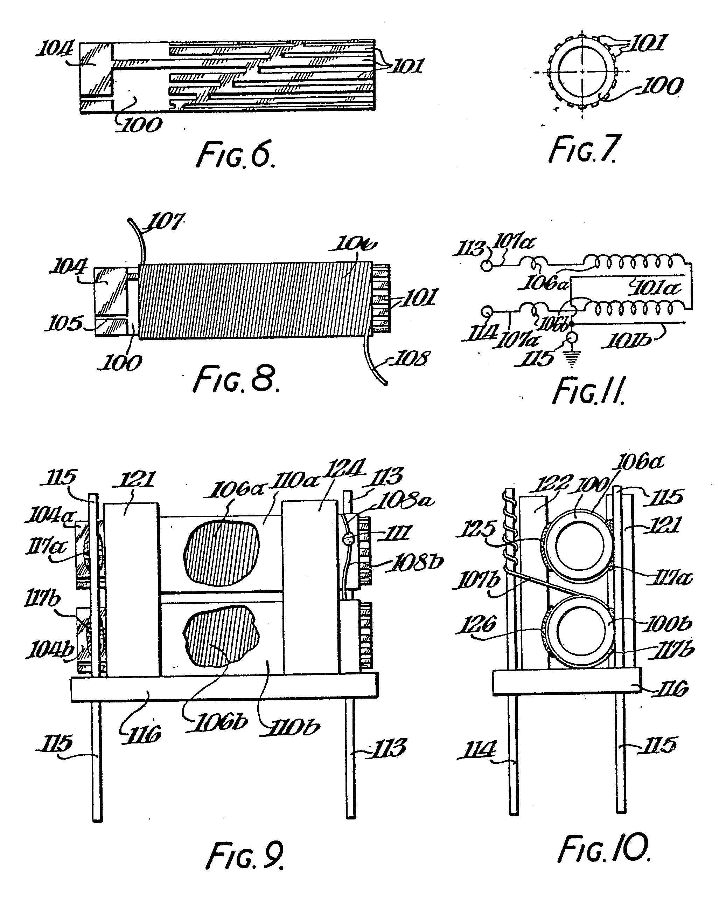

Figure 3 shows a dual section delay-line of the type described above with reference to Figure 1 in a package having a high frequency aluminium shield 50. Two distributed parameter delay-line sections 51 and 52 are mounted side-by-side to an insulative base 53. The laterally adjacent coil ends of sections 51 and 52 are electrically interconnected by wire link 54. Connector pins 55, 56, and 57 each extend through base 53 serving as external terminals of the delay-line package. The free end (not shown) of the coil of section 51 is connected to pin 55. The ground planes (not shown) of the two mandrels are connected to "ground" pin 56, and the free end 58 of the coil of section 52 is connected to pin 57.

The conductive "ground plane" pattern on the surface of mandrel 70 shown in Figure 4 is suitable for certain delay-lines constructed as described above, particularly those having continuously wound coils with broadly spaced turns, as illustrated in Figure 1. This pattern consists of uniformly wide strips 71, 72 and 73 running in an axial direction and being connected by a ring termination portion 74 that may have a slot 75 therein to avoid any shorted turn transformer effect in relation to a coil having an end very close to either of the rings 74.

However, for close wound single or multiple layer coils, the incremental inductance (inductance per unit length in an axial direction) is significantly smaller near the ends of the coil than in the middle regions. The ground plane pattern in Figure 4 leads to an incremental coil to ground plane capacitance that is essentially the same at every segment along the coil. Consequently the ratio of incremental inductance to incremental capacitance decreases near the ends of the coil causing a reduced incremental characteristic impedance there. This, as has been noted above, causes distortion of signals passing through the delay-line, being particularly objectionable at the series interconnection region of the dual section delay-line of this invention.

The surface of mandrel 80 in Figure 5 also has a ground plane pattern consisting of axially running strips 81, 82 and 83 being connected by a ring portion 84. Slot 85 is provided for the same reason as slot 75 in Figure 4.

Four axially directed regions A, B, C and D of the mandrels of Figures 4 and 5 are indicated under the Figures. Region A corresponds to the ground plane termination region. Regions B, C and D are to support a coil of a delay-line section. The modified ground plane pattern of Figure 5 is seen to have a progressively smaller conductive surface area toward the two coil ends (namely in regions B and D) than in the central coil region C. In this manner the characteristic impedance of every segment of the delay-line section may be the same value and distortion due to diminishing inductance per unit length at the end of a coil may be effectively eliminated.

Another preferred embodiment of this invention is illustrated in Figures 6 to 10. Figures 6 and 7 show a mandrel 100 in the form of a glass tube having an outer diameter of 5 mm and a length of 21 mm. A ring 104 of precious metal e.g. silver is provided on the mandrel 100 and has an axial length of 2 mm and a spacing of 4 mm from fifteen of sixteen interconnected metallized strips 101, the sixteenth strip being used to connect the strips 101 to the ring 104. The strips 101 are 15 mm long and have a width of 0.4 mm. The spacing between the adjacent of the strips is 0.5 mm.

As shown in Figure 8, the mandrel 100 of Figure 6 is provided with a compound multilayer progressive wound coil 106 which consists of 500 turns of double polyurethane coated copper wire, which wire has a diameter of 0.06 mm. The delay-line section thus formed has a coil of axial length of 17 mm and start and finish wire ends, 107 and 108, respectively.

Two delay-line sections of the kind shown in Figure 8 are employed in the dual section delay-line of Figure 9. The corresponding structural elements of the second section are assigned the same numeral designations as in the first section, a lower case "a" and "b" being added to numeral designations of the first and second sections, respectively. Insulative sheets 110a and 110b may be wrapped about the coils. Coil ends 108a and 108b are connected by solder joint 111.

Three terminal wires 113, 114 and 115 are mounted in an insulative base plate 116. Coil ends 107a and 107b are solder connected to wires 113 and 114, respectively. The ground plane terminal rings 104a and 104b are connected by solder joints 117a and 117b, respectively. Insulative mounting blocks 121, 122, (123 not shown) and 124 assist in the physical mounting of the two sections (e.g. by glue bonds 125, and 126) to the base plate 116. The space between the two coils is 0.5 mm, as seen in Figure 9.

The circuit diagram of the delay-line of Figure 9 is shown in Figure 11. In view of its similarity to that shown in Figure 2 it is not thought necessary to describe Figure 11 in detail.

The above-described delay-line of Figure 9 was built and found to have a delay time of 470 nano-seconds and a characteristic impedance of 1800 ohms. The noise voltage generated by a 15 KHz magnetic field was attenuated more than 25 db over that obtained by a delay-line employing the same two sections that were rearranged to be coaxial whereby the two interconnected coils had the same winding directions as would be seen by an observer proceeding from one coil to the other.

## Claims

1. A distributed parameter electromagnetic delay-line comprises essentially indentical delay-line sections (10, 20) each of said sections comprising an elongated mandrel (11, 21) with at least portions (12, 22) of the surface thereof being electrically conductive, a continuous wire coil (14, 24) being wound about the mandrel (11, 21) and insulated from said conductive portions, the conductive portions (12, 22) of each delay-line section (11, 21) being electrically interconnected with a coil end (14a) of one and a coil end (24a) of the other of said sections (10, 20) being electrically interconnected, and the mandrels (11, 21) positioned side-by-side with their axes (11a, 21a) being mutually parallel, the interconnected coil ends (14a, 24a) being two laterally adjacent ends, the winding directions of the coils being the same with respect to one axial direction whereby said coil (14, 24) has a continuously distributed capacitance to said conductive surface of said mandrel and a uniform unidirectional magnetic field of slowly varying magnitude having flux lines parallel to said mandrel axes will produce no voltage between the free ends of said interconnected coils characterised in that there are only two delay line sections, in that the mandrel (11, 21) of each section (10, 20) is provided with a single coil forming a uniform winding from one end to the other end thereof along said mandrel (11, 21).

2. A delay line according to claim 1, wherein the body of said mandrel (11, 21) is of an insulative material, said conductive surface portions (12, 22) thereof being a metal film having a pattern consisting of an open ring (74) that is circumferential to said mandrel at one end thereof and a plurality of elongated strips (71, 72, 73) being parallel to said axes and being connected to said ring (74), said coil (14, 24) being wound over said strips.

3. A delay-line according to claim 2 wherein the area per incremental unit length in an axial direction of said pattern is less near at least one end of said mandrel than in a central region between said one end and the other end of said mandrel.

4. A delay-line according to claim 1, 2 or 3 and including a metal shield having a magnetic permeability near unity, said shield being positioned about said two sections.

5. A delay-line according to claim 4 wherein said shield has a minimum spacing from said sections that is from 0.15 to 0.6 times the outside diameter of one of said coils.

6. A delay-line according to claim 5 or 6 wherein said metal is selected from copper and aluminium.

**Revendications**

1. Use ligne à retard électromagnétique à paramètres répartis comprend des sections (10, 20) principalement identiques de ligne à retard, chacune desdites sections comprenant un mandrin allongé (11, 21) ayant au moins des parties (12, 22) de sa surface qui sont électriquement conductrices, une bobine de fil continu (14, 24) étant enroulée autour du mandrin (11, 21) et isolée desdites parties conductrices, les parties conductrices (12, 22) de chaque section (11, 21) de ligne à retard étant électriquement interconnectées par le fait qu'une extrémité de bobine (14a) de l'une et une extrémité de bobine (24a) de l'autre desdites sections (10, 20) sont électriquement interconnectées, et les mandrins (11, 21) positionnés côte à côte de façon que leurs axes (11a, 21a) soient mutuellement parallèles, les extrémités de bobine interconnectées (14a, 24a) étant deux extrémités latéralement adjacentes, les sens d'enroulement des bobines étant identiques relativement à une direction axiale de sorte que ladite bobine (14, 24) a une capacité continûment répartie vis-à-vis de ladite surface conductrice dudit mandrin et un champ magnétique unidirectionnel uniforme d'amplitude variant lentement dont les lignes de flux sont parallèles auxdits axes des mandrins ne produira aucune tension entre les extrémités libres desdites bobines interconnectées, caractérisée en ce qu'il n'y a que deux sections de ligne à retard, en ce que le mandrin (11, 21) de chaque section (10, 20) est doté d'une unique bobine formant un enroulement uniforme d'une de ses extrémités à l'autre suivant ledit mandrin (11, 21).

2. Ligne à retard selon la revendication 1, où le corps dudit mandrin (11, 21) est en un matériau isolant, lesdites parties de surface conductrices (12, 22) de celui-ci étant une pellicule métallique formant un dessin qui consiste en un anneau ouvert (74) qui entoure ledit mandrin à l'une de ses extrémités et en plusieurs bandes allongées (71, 72, 73) qui sont parallèles auxdits axes et sont connectées audit anneau (74), ladite bobine (14, 24) étant enroulée par-dessus lesdites bandes.

3. Ligne à retard selon la revendication 2, caractérisée en ce que l'aire par unité de longueur incrémentielle suivant une direction axiale dudit dessin est plus petite au voisinage d'au moins une extrémité dudit mandrin que dans une région centrale entre ladite première extrémité et l'autre extrémité dudit mandrin.

4. Ligne à retard selon la revendication 1, 2 ou 3 et comportant un blindage métallique ayant une perméabilité magnétique voisine de l'unité, ledit blindage étant placé autour desdites deux sections.

5. Ligne à retard selon la revendication 4, où ledit blindage présente un écartement minimal vis-à-vis desdites sections qui est de 0,15 à 0,6 fois le diamétre extérieur d'une desdites bobines.

6. Ligne à retard selon la revendication 5 ou 6, où ledit métal est choisi parmi le cuivre et l'aluminium.

**Patentansprüche**

1. Elektromagnetische Verzögerungsleitung mit verteiltem Parameter bestehend aus im wesentlichen identischen Verzögerungsleitungsabschnitten (10, 20), wobei jeder der genannten Abschnitte einen länglichen Kern (11, 21) aufweist, von dem zumindest Teile (12, 22) seiner Oberfläche elektrisch leitend sind, einer kontinuierlichen Drahtwicklung (14, 24), die um den Kern (11, 21) gewickelt und von den genannten leitenden Teilen isoliert ist, wobei die leitenden Teile (12, 22) jedes Verzögerungsleitungsabschnittes (11, 21) elektrisch miteinander verbunden sind, mit einer elektrischen Verbindung von einem Wicklungsende (14a) mit dem einen und von einem Wichlungsende (24a) mit dem anderen der genannten Abschnitte (10, 20), und wobei die Kerne (11, 21) nebeneinander mit ihren Achsen (11a, 21a) wechselseitig parallel zueinander angeordnet sind, die miteinander verbundenen Wicklungsenden (14a, 24a) zwei seitlich benachbarte Enden sind, die Wicklungsrichtungen der Wicklungen bezüglich einer axialen Richtung die gleichen sind, wodurch die genannte Wicklung (14, 24) eine kontinuierlich verteilte Kapazität auf der genannten leitenden Oberfläche des genannten Kerns besitzt, und wobei ein einheitliches in einer Richtung ausgerichtetes Magnetfeld von sich langsam ändernder Größe, das Flußlinien parallel zu den genannten Kernachsen aufweist, keine Spannung zwischen den freien Enden der genannten miteinander verbundenen Wicklungen erzeugt, dadurch gekennzeichnet, daß nur zwei Verzögerungsleitungsabschnitte vorgesehen sind, daß der Kern (11, 12) jedes Abschnitts (10, 20) mit einer einzigen Wicklung versehen ist, die eine gleichförmige Wicklung von einem Ende zum anderen derselben längs des genannten Kerns (11, 21) bildet.

2. Verzögerungsleitung nach Anspruch 1, bei dem der Körper des genannten Kerns (11, 21) aus einem isolierendem Material ist, wobei die genannten leitenden Oberflächenteile (12, 22) desselben ein Metallfilm ist, der ein Muster besitzt, das aus einem offenen Ring (74) besteht, der umfangsmäßig zu dem genannten Kern an dessen einen Ende verläuft, und aus einer Vielzahl länglicher Streifen (71, 72, 73), die parallel zu den genannten Achsen verlaufen und mit dem genannten Ring (74) verbunden sind, wobei die genannte Wicklung (14, 24) über die genannten Streifen gewunden ist.

3. Verzögerungsleitung nach Anspruch 2, bei der die Fläche pro inkrementaler Einheitslänge in einer axialen Richtung des genannten Musters nahe zumindest dem einen Ende des genannten Kerns geringer ist, als in einem zentralen Bereich zwischen dem genannten einen Ende und dem anderen Ende des genannten Kerns.

4. Verzögerungsleitung nach Anspruch 1, 2, oder 3, um mit einer Metallabschirmung, die eine magnetische Permeabilität in der Nähe von 1 besitzt, wobei die genannte Abschirmung um die beiden genannten Abschnitte angeordnet ist.

5. Verzögerungsleitung nach Anspruch 4, bei der die genannte Abschirmung einen Minimalabstand von den genannten Abschnitten aufweist, der von 0,15 bis 0,6 mal dem Außendurchmesser einer der genannten Wicklungen ist.

6. Verzögerungsleitung nach Anspruch 5 oder 6, bei der das genannte Metall ausgewählt ist von Kupfer und Aluminium.

0 001 925

FIG. 1.

FIG. 2.

FIG. 3.

FIG. 4.

FIG. 5.

1

FIG.6.

FIG.7.

FIG.8.

FIG.11.

FIG.9.

FIG.10.

2